# EUROPÄISCHE PATENTANMELDUNG

(11) **EP 0 735 681 A2**
(43) Veröffentlichungstag der Anmeldung: **02.10.1996**
(21) Anmeldenummer: 95118927.3
(22) Anmeldetag: 01.12.1995
(51) Int. Cl.: H03K 17/082

(54) **Schaltungsanordnung zum Schalten einer elektrischen Last**

(30) Priorität: 27.03.1995 DE 19511199
(71) Anmelder: ROBERT BOSCH GMBH, 70442 Stuttgart (DE)
(72) Erfinder: Berling, Claude, Dipl.-Ing., F-67410 Drusenheim (FR)

(57) **Zusammenfassung**

Es wird eine Schaltungsanordnung zum Schalten einer elektrischen Last (10) vorgeschlagen, die eine Begrenzung oder ein Kurzschließen eines für einen ersten Schalttransistor (15) vorgesehenen Steuersignals (18) in Abhängigkeit vom Spannungsabfall (17) vorsieht, der an einer Schaltstrecke (14) des ersten Schalttransistors (15) auftritt, und der in Reihe mit der Last (10) geschaltet ist. Der Verbindungspunkt (25), an dem sowohl die Last (10) als auch der erste Schalttransistor (15) angeschlossen sind, ist über eine erste Diode (26) mit dem Steuereingang (21) eines zweiten Schalttransistors (22) verbunden, dessen Schaltstrecke (24) das Steuersignal (18) für den ersten Schalttransistor (15) begrenzt oder kurzschließt. Weiterhin ist dem Steuereingang (21) des zweiten Schalttransistors (22) das Steuersignal (18) für den ersten Schalttransistor (15) über eine Abschaltverzögerung (20) zugeführt. Die erfindungsgemäße Schaltungsanordnung stellt mit einfachsten Mitteln einen kurzschlußfesten Ausgang zum Schalten der Last (10) bereit.

## Beschreibung

### Stand der Technik

Die Erfindung betrifft eine Schaltungsanordnung zum Schalten einer elektrischen Last. Aus der DE-OS 43 16 185 ist eine derartige Schaltungsanordnung bekannt, die einen Transistor enthält, dessen Schaltstrecke in Serie mit der Last geschaltet ist. Die vorbekannte Schaltungsanordnung enthält eine Überwachungsschaltung, die in Abhängigkeit von der an der Schaltstrecke des Transistors abgreifbaren Spannung die Steuerspannung des Transistors reduziert oder ganz abschaltet, wobei das von einer Steuerschaltung abgegebene Steuersignal für den Transistor auf einen Wert festgelegt ist, der den über die Schaltstrecke des Transistors fließenden Strom auf einen vorgegebenen maximalen Wert begrenzt. Zur Begrenzung des Steuersignals des ersten Transistors ist ein zweiter Transistor vorgesehen, der über eine Zenerdiode und einen Arbeitspunkteinstellwiderstand für die Zenerdiode mit dem Verbindungspunkt von Schalttransistor und Last verbunden ist. Gegebenenfalls kann eine Zeitverzögerung vorgesehen sein, die mit dem Emitteranschluß des zweiten Transistors verbunden ist. Die Zeitverzögerung ermöglicht das zeitbegrenzte Fließen eines erhöhten Einschaltstroms durch die Last.

Der Erfindung liegt die Aufgabe zugrunde, die Funktionen der vorbekannten Schaltungsanordnung mit besonders einfachen Mitteln zu realisieren.

Die Aufgabe wird durch die im unabhängigen Anspruch enthaltenen Merkmale gelöst.

### Vorteile der Erfindung

Die erfindungsgemäße Schaltungsanordnung berücksichtigt einen Spannungsabfall an einer Schaltstrecke eines in Reihe mit der Last geschalteten ersten Schalttransistors. Ein Überschreiten des Spannungsabfalls eines vorgegebenen Schwellenwertes führt zum Reduzieren oder vollständigen Kurzschließen des für den ersten Schalttransistor vorgesehenen Steuersignals. Die erfindungsgemäße Schaltungsanordnung verhindert somit das Ansteigen des Spannungsabfalls an der Schaltstrecke des ersten Schalttransistors bei einem gleichzeitig vorliegenden Einschaltsignal auf unzulässig hohe Werte, die den ersten Schalttransistor aufgrund der unzulässigen Erhöhung der Verlustleistung gefährden würde. Insbesondere ein teilweiser oder vollständiger Kurzschluß der Last führen sofort zu einem Reduzieren oder einem Kurzschließen des für den ersten Schalttransistor vorgesehenen Steuersignals und somit zum Abschalten des ersten Transistors.

Erfindungsgemäß ist wenigstens eine erste Diode vorgesehen, die den Steuereingang des zweiten Schalttransistors unmittelbar mit dem Verbindungspunkt von erstem Schalttransistor und Last verbindet. Die erforderliche Entkopplung zwischen dem für den ersten Schalttransistor vorgesehenen Steuersignal und dem Steuereingang des zweiten Schalttransistors ist eine Abschaltverzögerung vorgesehen, die dem Steuereingang des zweiten Schalttransistors das Steuersignal für den ersten Schalttransistor zeitverzögert zuführt. Neben der Entkopplung, die erforderlich ist, um eine Arbeitsspannung für die wenigstens eine erste Diode bereitzustellen, läßt die Abschaltverzögerung das zeitbegrenzte Fließen eines erhöhten Einschaltstromes durch die Last zu.

Der zulässige Spannungsabfall an der Schaltstrecke des ersten Schalttransistors ist im wesentlichen von der Durchlaßspannung der wenigstens einen ersten Diode und von der am Steuereingang des zweiten Schalttransistors liegenden Steuerspannung des zweiten Schalttransistors abhängig. In Abhängigkeit von der Steuerspannung des zweiten Schalttransistors können gegebenenfalls mehrere erste Dioden vorgesehen sein.

Die erfindungsgemäße Schaltungsanordnung weist den wesentlichen Vorteil der besonders kostengünstigen Realisierung auf, da lediglich wenige Bauelemente benötigt werden. Wenige Bauelemente beanspruchen auf einer Leiterplatte wenig Platz und führen deshalb nochmals zu einer Kostenreduzierung.

Vorteilhafte Weiterbildungen und Ausgestaltungen der erfindungsgemäßen Schaltungsanordnung ergeben sich aus abhängigen Ansprüchen.

Eine besonders einfache Realisierung der Abschaltverzögerung sieht eine Wiederstands-Kondensator-Kombination vor, die als Tiefpaßschaltung aufgebaut ist. Die Abschaltverzögerung ist mit dieser Maßnahme mit lediglich zwei Bauelementen realisierbar.

Eine vorteilhafte Weiterbildung sieht den Einsatz wenigstens einer zweiten Diode vor, die vor den Steuereingang des zweiten Schalttransistors geschaltet ist. Die wenigstens eine zweite Diode ermöglicht eine Anpassung an unterschiedliche Schwellenwerte der Spannungsbegrenzung an der Schaltstrecke des ersten Schalttransistors, die insbesondere bei geringen Steuerspannungen des zweiten Schalttransistors, die im Bereich einer Diodendurchlaßspannung liegen, zum Tragen kommt.

Eine andere vorteilhafte Weiterbildung sieht vor, daß das für den ersten Schalttransistor vorgesehene Steuersignal über einen Strombegrenzungswiderstand zum Steuereingang des ersten Schalttransistors geführt ist. Der Strombegrenzungswiderstand begrenzt den durch ersten Schalttransistor fließende Strom auf einen vorgegebenen Wert. Diese Begrenzung arbeitet unabhängig von der übrigen Schaltungsanordnung. Mit dieser Maßnahme kann sichergestellt werden, daß der erste Schalttransistor im Falle eines Überlastzustands stets im sicheren Arbeitsbereich bleibt. Selbst ein nur kurzzeitiges Verlassen des sicheren Arbeitsbereichs wird vermieden.

Weitere vorteilhafte Weiterbildungen und Ausgestaltungen ergeben sich aus der folgenden Beschreibung.

### Zeichnung

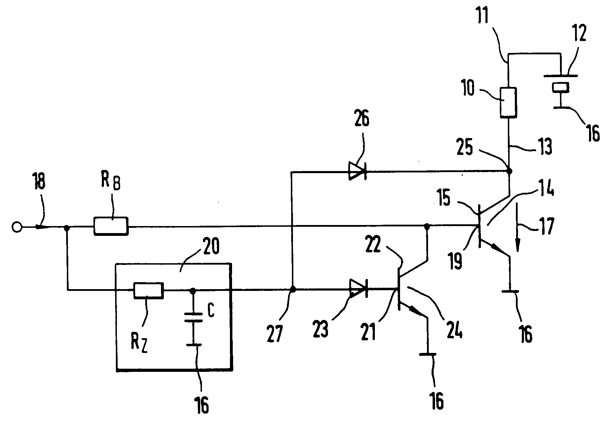

Die Figur zeigt ein Schaltbild eines Ausführungsbeispiels einer erfindungsgemäßen Schaltungsanordnung zum Schalten einer elektrischen Last.

Eine Last 10 ist über einen ersten Anschluß 11 mit einer Energiequelle 12 verbunden. Ein zweiter Anschluß 13 der Last 10 ist über eine Schaltstrecke 14 eines ersten Schalttransistors 15 ebenfalls mit der Energiequelle 12 verbindbar. Die Schaltstrecke 14 führt vom zweiten Anschluß 13 zu einer Masse 16, an die die Energiequelle 12 geschaltet ist. An der Schaltstrecke 14 tritt ein Spannungsabfall 17 auf.

Zum Ein- und Ausschalten der Last 10 ist ein Steuersignal 18 vorgesehen, das über einen Strombegrenzungswiderstand R_{B} einem Steuereingang 19 des ersten Schalttransistors 15 zugeführt ist. Das Steuersignal 18 gelangt weiterhin über eine Abschaltverzögerung 20 an einen Steuereingang 21 eines zweiten Schalttransistors 22. Zwischen dem Steuereingang 21 des zweiten Schalttransistors 22 und der Abschaltverzögerung liegt eine Diode 23, die im folgenden als zweite Diode 23 bezeichnet wird.

Die Schaltstrecke 24 des zweiten Schalttransistors 22 liegt zwischen dem Steuereingang 19 des ersten Schalttransistors 15 und der Masse 16. Von einem Verbindungspunkt 25, an dem sowohl die Last 10 als auch der erste Schalttransistor 15 angeschlossen sind, führt eine erste Diode 26 zu einem Verbindungspunkt 27, an dem die Abschaltverzögerung 20 und die zweite Diode 23 angeschlossen sind.

Die Abschaltverzögerung 20 enthält eine Tiefpaßfilterschaltung, die mit einem Zeitverzögerungswiderstand R_{Z} und mit einem Kondensator C realisiert ist.

Die erfindungsgemäße Schaltungsanordnung zum Schalten der elektrischen Last 10 arbeitet folgendermaßen:

Das Steuersignal 18, das über den Strombegrenzungswiderstand R_{B} dem Steuereingang 19 des ersten Schalttransistors 15 zugeführt ist, legt das Ein- und Abschalten der Last 10 fest. Das Steuersignal 18 veranlaßt die Verbindung des zweiten Anschlusses 13 der Last 10 über die Schaltstrecke 14 des ersten Schalttransistors 15 mit Masse 16. Sofern es sich bei dem ersten Schalttransistor 15 um ein stromverstärkendes Halbleiterbauelement, beispielsweise einen Bipolartransistor handelt, kann mit dem Strombegrenzungswiderstand R_{B} der durch den ersten Schalttransistor 15 fließende Strom auf einen vorgegebenen maximalen Wert begrenzt werden. Der Strombegrenzungswiderstand R_{B} ist in Abhängigkeit von der Spannung des Steuersignals 18 und dem Stromverstärkungsfaktor des ersten Schalttransistors 15 festzulegen. Ein über das Steuersignal 18 vorgegebener Einschaltbefehl schaltet den ersten Schalttransistor 15 ein und verbindet die Last 10 mit der Energiequelle 12.

Ein durch den ersten Schalttransistor 15 fließender Strom führt an der Schaltstrecke zu einem Spannungsabfall 17, welcher der Sättigungsspannung des ersten Schalttransistors 15 entspricht. Die Sättigungsspannung ist stromabhängig und liegt bei einem Bipolartransistor im Bereich von näherungsweise 0,1 bis 0,3 Volt. Ein gegenüber den erwarteten Werten erhöhter Spannungsabfall 17 kann bedeuten, daß der erste Schalttransistor 15 einen Defekt aufweist. Insbesondere tritt ein erhöhter Spannungsabfall 17 aber bei einem Fehler in der Last 10 auf. Ein solcher Fehler ist beispielsweise ein teilweiser oder insbesondere ein vollständiger Kurzschluß in der Last 10. Bei einem Durchschalten des ersten Schalttransistors 15 würde bei einem Kurzschluß in der Last 10 nahezu die gesamte von der Energiequelle 10 bereitgestellte Spannung als Spannungsabfall 17 am ersten Schalttransistor 15 auftreten. Eine hohe Spannung und der gleichzeitig fließende Strom würde zu einem Verlassen des sicheren Arbeitsbereichs führen, der für Halbleiterbauelemente charakteristisch ist. Selbst dann, wenn der sichere Arbeitsbereich nicht verlassen wird, muß damit gerechnet werden, daß der erste Schalttransistor 15 in kurzer Zeit thermisch zerstört wird. Eine Strombegrenzung in diesem Fall ist mit dem Strombegrenzungswiderstand R_{B} auf einen vorgegebenen maximalen Wert möglich. Der maximale Strom hat aber nur bedingt Einfluß auf den Spannungsabfall 17. Eine erhebliche Erhöhung der Sicherheit gegenüber dem unzulässigen Betriebszustand ist durch eine Berücksichtigung des Spannungsabfalls 17 bei der Ansteuerung des ersten Schalttransistors 15 möglich.

Der gegenüber Masse 16 am Verbindungspunkt 25 abgreifbare Spannungsabfall 17 gelangt über die erste Diode 26 auf den Steueranschluß 21 des zweiten Schalttransistors 22. Die erste Diode 26 ist im leitenden Zustand, wenn die Spannung am Verbindungspunkt 27, an dem das für den ersten Schalttransistor 15 vorgesehene Steuersignal 18 liegt, um eine Durchlaßspannung der ersten Diode 26 höher ist als der Spannungsabfall 17. Ohne Berücksichtigung der zweiten Diode 23 ist demnach die am Steuereingang 21 des zweiten Schalttransistors 22 liegende Spannung ein Wert, der sich aus der Addition des Spannungsabfalls 17 und der Durchlaßspannung der ersten Diode 26 ergibt. Steigt der Spannungsabfall 17, dann steigt gleichfalls die Spannung am Steuereingang 21 des zweiten Schalttransistors 22. Beim Überschreiten der Einschaltschwelle des zweiten Schalttransistors 22 wird über dessen Schaltstrecke 24 die Spannung am Steuereingang 19 des ersten Schalttransistors 15 begrenzt oder vollständig gegen Masse 16 kurzgeschlossen. Der Spannungsabfall 17 am ersten Schalttransistor 15 kann demnach über den vorgegebenen Schwellenwert nicht weiter ansteigen.

Unter der Annahme, daß der zweite Schalttransistor 22 eine Schaltspannung von beispielsweise 0,7 Volt aufweist und unter der Annahme, daß als erste Diode 26 eine Diode mit einer Durchlaßspannung von gleichfalls näherungsweise 0,7 Volt zum Einsatz gelangt, wäre nur ein kleiner Spielraum für den zulässigen Spannungsabfall 17 realisierbar. Eine Erhöhung der Schwellenspannung für den zulässigen Wert des Spannungsabfalls 17 ist durch den Einsatz der zweiten Diode 23 mit einfachen Mitteln möglich. Die Diode 23 erhöht die Einschaltspannung des zweiten Schalttransistors 22 um durch Durchlaßspannung der zweiten Diode 23. Gegebenenfalls können weitere zweite Dioden 23 vorgesehen sein.

Sofern die Einschaltspannung des zweiten Schalttransistors 22 im Bereich von einigen Volt liegt, wie sie beispielsweise bei Feldeffekttransistoren auftreten kann, wird eine Anpassung durch den Einsatz von weiteren ersten Dioden 26 möglich, deren Durchlaßspannungen zu dem Spannungsabfall 17 addiert werden.

Das in der Figur gezeigte Ausfübrungsbeispiel mit einer ersten Diode 26 und einer zweiten Diode 23 hat sich als kostengünstigste Realisierungsmöglichkeit einer Schaltungsanordnung gezeigt, bei der die beiden Dioden 23, 26 Siliziumdioden und die beiden Schalttransistoren 15, 22 Silizium-Bipolartransistoren sind.

Die Abschaltverzögerung 20 hat zunächst die Aufgabe, den Verbindungspunkt 27 mit dem Steuersignal 18 zu verbinden. Am Verbindungspunkt 27 muß eine Spannung anliegen, die stets einen Wert aufweist, der ausreicht, der ersten Diode 26 und gegebenenfalls der zweiten Diode 23 eine Arbeitsspannung zur Verfügung zu stellen. Zur Entkopplung ausreichend wäre bereits ein Entkopplungswiderstand. Erfindungsgemäß ist neben dem Entkopplungswiderstand die als Tiefpaß geschaltete Widerstands-Kondensator-Kombination R_{Z}, C vorgesehen, die als Tiefpaßfilterschaltung ausgeführt ist und eine entsprechende Zeitverzögerung bewirkt. Neben dem Entkoppeln des Verbindungspunktes 27 vom Steuersignal 18 ermöglicht die Abschaltverzögerung 20 somit das Berücksichtigen von Einschaltvorgängen in der Last 10, die zu einem kurzzeitig erhöhten Stromfluß führen können. Ein solches Verhalten einer Last 10 tritt beispielsweise bei einer ohmschen Last auf, deren Widerstand im abgeschalteten Zustand geringer ist als im betriebswarmen Zustand. Die Abschaltverzögerung 20 wirkt lediglich bei einem Wechsel des Steuersignals 18 von einem Abschalt- zu einem Einschaltsignal. Ein während des normalen Betriebs auftretender Defekt in der Last 10, der zu einem erhöhten Stromfluß durch die Last 10 führen würde, führt sofort zum Begrenzen oder Kurzschließen der Spannung am Steuereingang 19 des ersten Schalttransistors 15. In diesem Fall tritt keine Verzögerung durch die Abschaltverzögerung 20 auf.

## Patentansprüche

1. Eine Schaltungsanordnung zum Schalten einer elektrischen Last enthält die Merkmale:
- es ist ein erster Schalttransistor (15) vorgesehen, dessen Schaltstrecke (14) in Reihe mit der Last (10) geschaltet ist;
- dem Steuereingang (19) des ersten Schalttransistors (15) ist ein Schaltsignal (18) zum Ein- und Ausschalten der Last (10) zugeführt;
- es ist ein zweiter Schalttransistor (22) vorgesehen, der das Steuersignal (18) des ersten Schalttransistors (15) begrenzt oder kurzschließt;
- dem Steuereingang (21) des zweiten Schalttransistors (22) ist das über eine Abschaltverzögerung (20) geführte Steuersignal (18) des ersten Schalttransistors (15) zugeführt;
- der Steuereingang (21) des zweiten Schalttransistors (22) ist weiterhin über wenigstens eine erste Diode (26) mit einem Verbindungspunkt (25) verbunden, an dem sowohl die Last (10) als auch der erste Schalttransistor (15) angeschlossen sind.

2. Schaltungsanordnung nach Anspruch 1, bei der die Abschaltverzögerung (20) eine als Tiefpaßfilterschaltung ausgeführte Widerstands-Kondensator-Kombination (R_{Z}, C) enthält.

3. Schaltungsanordnung nach Anspruch 1, bei der wenigstens eine zweite Diode (23) vor den Steuereingang (21) des zweiten Schalttransistors (22) geschaltet ist.

4. Schaltungsanordnung nach Anspruch 1, bei der der Steuereingang (19) des ersten Schalttransistors (15) über einen Strombegrenzungswiderstand (R_{B}) mit dem Steuersignal (18) beaufschlagt ist.
